# EUROPEAN PATENT APPLICATION

(11) **EP 4 040 502 A1**
(43) Date of publication of application: **10.08.2022**
(21) Application number: 22155142.7
(22) Date of filing: 04.02.2022
(51) Int. Cl.: H01L 29/78, H01L 29/08, H01L 21/266, H01L 21/04

(54) **SEMICONDUCTOR DEVICE MANUFACTURING METHOD AND SEMICONDUCTOR DEVICE**

(30) Priority: 05.02.2021 CN 202110169971
(71) Applicant: Huawei Technologies Co., Ltd., Longgang District Shenzhen, Guangdong 518129 (CN)
(72) Inventor: WANG, Xin, Shenzhen, 518129 (CN); HOU, Zhaozheng, Shenzhen, 518129 (CN); WANG, Yiyu, Shenzhen, 518129 (CN); GAO, Yunbin, Shenzhen, 518129 (CN); HU, Fei, Shenzhen, 518129 (CN); HU, Lang, Shenzhen, 518129 (CN)
(74) Representative: Körber, Martin Hans

(57) **Abstract**

Embodiments of this application provide a semiconductor device manufacturing method and a semiconductor device, to form a self-aligned channel with a smaller size and better uniformity to reduce conduction resistance of the semiconductor device, thereby improving a yield rate of the semiconductor device and reducing manufacturing costs of the semiconductor device. In the method, a barrier layer used to form a well region includes a first hard mask and a second hard mask, and a barrier layer used to form a source region includes only the first hard mask. It is clearly that a thickness of the barrier layer used to form the source region is less than a thickness of the barrier layer used to form the well region. In other words, the thickness of the barrier layer used to form the source region is reduced, so that a side wall with a smaller size can be obtained, so as to form a self-aligned channel with a smaller size and better uniformity.

## Description

### TECHNICAL FIELD

This application relates to the semiconductor field, and in particular, to a semiconductor device manufacturing method and a semiconductor device.

### BACKGROUND

A semiconductor device is an electronic device whose conductivity is between conductivity of a good conductor and that of an insulator, and completes a specific function by using a special electrical feature of a semiconductor material, and may be used to generate, control, receive, transform, and amplify a signal, and perform energy conversion. A commonly used metal-oxide semiconductor field-effect transistor (metal-oxide semiconductor field-effect transistor, MOSFET) is used as an example. The MOSFET may also be referred to as a MOS transistor. The MOS transistor is widely used in a high-voltage and large-current scenario, such as an inverter, a switch power supply, or a motor drive.

Generally, in a process of manufacturing a semiconductor device, high-energy ion needs to be implanted on a surface of the semiconductor device a plurality of times to form a well region, a source region, and a channel (channel). Conduction resistance of the semiconductor device is an important parameter for measuring quality of the semiconductor device. The conduction resistance is directly associated with an area of the semiconductor device, and the conduction resistance is positively correlated with the area of the semiconductor device. An increase in the area of the semiconductor device directly causes an increase in manufacturing costs of the semiconductor device.

Therefore, how to reduce the conduction resistance of the semiconductor device to improve a yield rate of the semiconductor device and reduce manufacturing costs of the semiconductor device is an urgent technical problem to be resolved.

### SUMMARY

Embodiments of this application provide a semiconductor device manufacturing method and a semiconductor device, to form a self-aligned channel with a smaller size and better uniformity to reduce conduction resistance of the semiconductor device, thereby improving a yield rate of the semiconductor device and reducing manufacturing costs of the semiconductor device.

A first aspect of the embodiments of this application provides a semiconductor device manufacturing method. The method may be applied to a process of manufacturing a semiconductor device, and may be specifically applied to a process of manufacturing a semiconductor device. Generally, conduction resistance of the semiconductor device is an important parameter for measuring quality of the semiconductor device, and larger conduction resistance indicates a larger device area of the semiconductor device. In addition, the conduction resistance of the semiconductor device is associated with a width of a channel in the semiconductor device. In the manufacturing method, the width of the channel in the semiconductor device is reduced to reduce the conduction resistance of the semiconductor device. Specifically, in the method, a semiconductor base is provided. Then, a first hard mask is deposited on a surface of the semiconductor base, and a second hard mask is deposited on the first hard mask. Next, the first hard mask and the second hard mask are etched through photolithography to form a hard mask pattern, and then a first ion is implanted on the surface of the semiconductor base, where the first ion is used to form a well region below a first region, and the first region is a region other than the hard mask pattern on the surface of the semiconductor base. Further, the second hard mask is removed to expose the first hard mask, and a side wall is formed in the first region based on the first hard mask. Afterwards, a second ion is implanted on the surface of the semiconductor base, where the second ion is used to form a source region below a second region and form a channel below a third region, the second region is a region that is in the first region and that is not covered by the side wall, and the third region is a region that is in the first region and that is covered by the side wall.

Based on the foregoing technical solution, a barrier layer used to form the well region includes the first hard mask and the second hard mask, and a barrier layer used to form the source region includes only the first hard mask. It is clearly that a thickness of the barrier layer used to form the source region is less than a thickness of the barrier layer used to form the well region. In other words, the thickness of the barrier layer used to form the source region is reduced, so that a side wall with a smaller size can be obtained, so as to form a self-aligned channel with a smaller size and better uniformity to reduce conduction resistance of the semiconductor device, thereby improving a yield rate of the semiconductor device and reducing manufacturing costs of the semiconductor device.

It should be noted that the first hard mask may include one layer of hard mask, or may include a plurality of layers of hard masks. In addition, when the first hard mask includes a plurality of layers of hard masks, composition components of different layers of hard masks may be the same or different. In this case, in a process of removing the first hard mask, etching (dry etching or wet etching) may be performed one or more times. This is not limited herein.

Similarly, the second hard mask may also include one layer of hard mask, or may include a plurality of layers of hard masks. In addition, when the second hard mask includes a plurality of layers of hard masks, composition components of different layers of hard masks may be the same or different. In this case, in a process of removing the second hard mask, etching (dry etching or wet etching) may be performed one or more times. This is not limited herein.

In a possible implementation of the first aspect of the embodiments of this application, after the implanting a first ion on the surface of the semiconductor base and before the removing the second hard mask, the method further includes:
depositing a photoresist on the surface of the semiconductor base, where the photoresist covers a surface of the first region; and
after the removing the second hard mask and before the forming a side wall in the first region based on the first hard mask, the method further includes:
   removing the photoresist.

Based on the foregoing technical solution, before the second hard mask is removed, the photoresist may be deposited on the surface of the semiconductor base to protect the surface of the semiconductor base from being etched in the process of removing the second hard mask. Afterwards, after the second hard mask is removed, the photoresist may be removed to expose the surface of the semiconductor base, so that a subsequent process of implanting the second ion is not affected by the photoresist, and the second ion can be directly implanted on the surface of the semiconductor base to form the source region and the channel.

In a possible implementation of the first aspect of the embodiments of this application, a thickness of the photoresist ranges from 0.3 microns to 3 microns.

In a possible implementation of the first aspect of the embodiments of this application, the photoresist further covers the second hard mask, and the process of removing the second hard mask specifically includes: removing the second hard mask after the photoresist covering the second hard mask is removed.

Based on the foregoing technical solution, the photoresist deposited on the surface of the semiconductor base not only covers the surface of the first region but also covers a surface of the second hard mask. In the subsequent process of removing the second hard mask, the photoresist covering the second hard mask is removed before the second hard mask is removed. The photoresist may be indiscriminately deposited in all regions on the surface of the semiconductor base, so that the photoresist covers the surface of the second hard mask and the surface of the first region, and the photoresist unnecessarily needs to be deposited in a specific region, thereby reducing complexity of depositing the photoresist on the surface of the semiconductor base.

In a possible implementation of the first aspect of the embodiments of this application, after the implanting a second ion on the surface of the semiconductor base, the method may further include: removing the first hard mask and the side wall.

Based on the foregoing technical solution, after the source region and the channel are formed below the surface of the semiconductor base, the first hard mask and the side wall that cover the surface of the semiconductor base may be further removed to expose the surface of the semiconductor base. Afterwards, gate oxide and a gate dielectric may be further generated on the exposed surface of the semiconductor base, and the gate oxide and the gate dielectric are etched to form a gate structure to meet a power-on requirement of the semiconductor device in a specific scenario.

In a possible implementation of the first aspect of the embodiments of this application, the semiconductor base includes an epitaxy (or referred to as an epitaxial layer), a substrate located on one side of the epitaxy, and an etching stop layer located on the other side of the epitaxy. The etching stop layer forms the surface of the semiconductor base. After the removing the first hard mask and the side wall, the method further includes: removing the etching stop layer.

Based on the foregoing technical solution, an ion needs to be implanted in a process of forming the well region, the source region, and the channel in the semiconductor device, and an ion implantation concentration presents a distribution curve in terms of depth of the semiconductor device, so that a surface of the semiconductor device is from small to large, subsequently becomes flat, and then descends. The etching stop layer is disposed outside the epitaxial layer in the semiconductor base, and the other side of the etching stop layer forms the surface of the semiconductor base, so that in an implantation process after the ion (including the first ion or the second ion) passes through the etching stop layer, damage to the epitaxial layer and the substrate can be reduced by disposing the etching stop layer, and a depth of the implanted ion can be implemented by controlling a thickness of the etching stop layer, thereby further improving a yield rate of the semiconductor device.

In a possible implementation of the first aspect of the embodiments of this application, the semiconductor base includes an etching stop layer and a substrate located on one side of the etching stop layer, and the other side of the etching stop layer forms the surface of the semiconductor base. After the removing the first hard mask and the side wall, the method may further include: removing the etching stop layer.

Based on the foregoing technical solution, an ion needs to be implanted in a process of forming the well region, the source region, and the channel in the semiconductor device, and an ion implantation concentration presents a distribution curve in terms of depth of the semiconductor device, so that a surface of the semiconductor device is from small to large, subsequently becomes flat, and then descends. The etching stop layer is disposed in the semiconductor base, and the other side of the etching stop layer forms the surface of the semiconductor base, so that in an implantation process after the ion (including the first ion or the second ion) passes through the etching stop layer, damage to the substrate can be reduced by disposing the etching stop layer, and a depth of the implanted ion can be implemented by controlling a thickness of the etching stop layer, thereby further improving a yield rate of the semiconductor device.

In a possible implementation of the first aspect of the embodiments of this application, the semiconductor base further includes an epitaxy (or referred to as an epitaxial layer), and the epitaxial layer is located between the etching stop layer and the substrate.

Based on the foregoing technical solution, the semiconductor base may further include the epitaxial layer located between the etching stop layer and the substrate. Implantation of the first ion and the second ion may form a well region, a source region, and a channel on the epitaxial layer, so that the present invention is applicable to a semiconductor structure including a substrate and an epitaxial layer, thereby improving implementability of the solution.

Optionally, the epitaxial layer has high resistivity relative to the substrate, and the substrate has low resistivity relative to the epitaxial layer. In this case, the epitaxial layer with high resistivity ensures that the semiconductor device has relatively high breakdown voltage, and the substrate with low resistivity can reduce resistance of the semiconductor device, thereby reducing a saturation voltage drop.

Optionally, the semiconductor base may include only the substrate.

Optionally, the semiconductor base may include only the substrate and the etching stop layer.

Optionally, the semiconductor base may include only the substrate and the epitaxial layer.

In a possible implementation of the first aspect of the embodiments of this application, a component of the second hard mask is different from a component of the first hard mask.

Based on the foregoing technical solution, the first hard mask and the second hard mask that have different components are disposed, so that in the process of removing the second hard mask, an etching condition that an etching rate at which the component of the second hard mask is etched is relatively large and an etching rate at which the component of the first hard mask is etched is relatively small may be set to reduce damage to the first hard mask in the process of removing the second hard mask.

In a possible implementation of the first aspect of the embodiments of this application, the component of the second hard mask and the component of the first hard mask both are silicon compounds.

Based on the foregoing technical solution, the silicon compound may include polycrystalline silicon, silicon nitride, silicon oxide, silicon carbide, and the like. The composition component of the first hard mask may be one silicon compound or a mixture of a plurality of silicon compounds. Similarly, the composition component of the second hard mask may also be one silicon compound or a mixture of a plurality of silicon compounds. In other words, the first hard mask and the second hard mask may be implemented in a plurality of manners, thereby improving implementability of the solution.

In a possible implementation of the first aspect of the embodiments of this application, an etching selectivity ratio of the second hard mask to the first hard mask is greater than 10 to 1.

Optionally, the etching selectivity ratio of the second hard mask to the first hard mask is greater than 1 to 1.

Based on the foregoing technical solution, the etching selectivity ratio may indicate a fast/low etching rate of one material relative to another material in a same etching condition. In the process of removing the second hard mask, damage to the first hard mask can be reduced in the process of removing the second hard mask, because the etching selectivity ratio of the second hard mask to the first hard mask is greater than 10 to 1, that is, in a specific etching condition, an etching rate of the second hard mask is far greater than an etching rate of the first hard mask.

In a possible implementation of the first aspect of the embodiments of this application, a thickness of the first hard mask ranges from 0.1 microns to 3 microns.

In a possible implementation of the first aspect of the embodiments of this application, a thickness of the second hard mask ranges from 0.1 microns to 3 microns.

In a possible implementation of the first aspect of the embodiments of this application, a component of the etching stop layer is a silicon compound.

Based on the foregoing technical solution, the silicon compound may include polycrystalline silicon, silicon nitride, silicon oxide, silicon carbide, and the like. The composition component of the etching stop layer may be one silicon compound or a mixture of a plurality of silicon compounds. In other words, the etching stop layer may be implemented in a plurality of manners, thereby improving implementability of the solution.

Optionally, the component of the etching stop layer is different from the component of the first hard mask.

Optionally, the component of the etching stop layer is different from the component of the second hard mask.

In a possible implementation of the first aspect of the embodiments of this application, a thickness of the etching stop layer ranges from 10 nanometers to 500 nanometers.

In a possible implementation of the first aspect of the embodiments of this application, the component of the etching stop layer is different from the component of the first hard mask.

In a possible implementation of the first aspect of the embodiments of this application, the component of the etching stop layer is different from the component of the second hard mask.

Based on the foregoing technical solution, the component of the etching stop layer is set to be different from the component of the first hard mask (or the second hard mask), and/or the component of the etching stop layer is set to be different from the component of the second hard mask, so that an etching condition may be controlled to avoid corrosion of the etching stop layer when the first hard mask (or the second hard mask) is etched.

In a possible implementation of the first aspect of the embodiments of this application, ion energy of the first ion is greater than ion energy of the second ion.

Based on the foregoing technical solution, ion energy of the first ion that is implanted on the surface of the semiconductor base and that is used to form the well region is greater than ion energy of the second ion that is implanted on the surface of the semiconductor base and that is used to form the source region and the channel. Because ion energy is positively correlated with an implantation depth, a depth of the well region formed below the surface of the semiconductor base is greater than a depth of the source region formed below the surface of the semiconductor base, thereby meeting depth requirements in different regions in the semiconductor device.

A second aspect of the embodiments of this application provides a semiconductor device. The semiconductor device is manufactured by using the method according to any one of the first aspect and possible implementations of the first aspect, and the semiconductor device includes a channel.

Optionally, the semiconductor device includes a MOS transistor.

A third aspect of the embodiments of this application provides a chip. The chip includes the semiconductor device according to the second aspect.

It can be learned from the foregoing technical solutions that the embodiments of this application have the following advantages: In the method, the semiconductor base is provided; the first hard mask is deposited on the surface of the semiconductor base; the second hard mask is deposited on the first hard mask; the first hard mask and the second hard mask are etched through photolithography to form the hard mask pattern; the first ion is implanted on the surface of the semiconductor base, where the first ion is used to form the well region below the first region, and the first region is a region other than the hard mask pattern on the surface of the semiconductor base; the photoresist is deposited on the surface of the semiconductor base, where the photoresist covers the surface of the first region; the second hard mask is removed; the photoresist is removed; the side wall is formed in the first region based on the first hard mask; and the second ion is implanted on the surface of the semiconductor base, where the second ion is used to form the source region below the second region and form the channel below the third region, the second region is a region that is in the first region and that is not covered by the side wall, and the third region is a region that is in the first region and that is covered by the side wall. The barrier layer used to form the well region includes the first hard mask and the second hard mask, and the barrier layer used to form the source region includes only the first hard mask. It is clearly that the thickness of the barrier layer used to form the source region is less than the thickness of the barrier layer used to form the well region. In other words, the thickness of the barrier layer used to form the source region is reduced, so that a side wall with a smaller size can be obtained, so as to form a self-aligned channel with a smaller size and better uniformity to reduce conduction resistance of the semiconductor device, thereby improving a yield rate of the semiconductor device and reducing manufacturing costs of the semiconductor device.

### BRIEF DESCRIPTION OF DRAWINGS

To describe the technical solutions in the present invention more clearly, the following briefly describes the accompanying drawings for describing the implementations. It is clearly that the accompanying drawings in the following description show merely some implementations of the present invention, and a person of ordinary skill in the art may still derive other drawings from these accompanying drawings without creative efforts.
FIG. 1 is a schematic diagram of forming a well region in a semiconductor device;
FIG. 2 is a schematic diagram of forming a source region in a semiconductor device;
FIG. 3 is a schematic diagram of a semiconductor device manufacturing method according to an embodiment of this application;
FIG. 4 is another schematic diagram of a semiconductor device manufacturing method according to an embodiment of this application;
FIG. 5 is another schematic diagram of a semiconductor device manufacturing method according to an embodiment of this application;
FIG. 6 is another schematic diagram of a semiconductor device manufacturing method according to an embodiment of this application;
FIG. 7 is another schematic diagram of a semiconductor device manufacturing method according to an embodiment of this application;
FIG. 8 is another schematic diagram of a semiconductor device manufacturing method according to an embodiment of this application;
FIG. 9 is another schematic diagram of a semiconductor device manufacturing method according to an embodiment of this application;
FIG. 10 is another schematic diagram of a semiconductor device manufacturing method according to an embodiment of this application;
FIG. 11 is another schematic diagram of a semiconductor device manufacturing method according to an embodiment of this application;
FIG. 12 is another schematic diagram of a semiconductor device manufacturing method according to an embodiment of this application;
FIG. 13 is another schematic diagram of a semiconductor device manufacturing method according to an embodiment of this application;
FIG. 14 is another schematic diagram of a semiconductor device manufacturing method according to an embodiment of this application;
FIG. 15 is another schematic diagram of a semiconductor device manufacturing method according to an embodiment of this application; and
FIG. 16 is another schematic diagram of a semiconductor device manufacturing method according to an embodiment of this application.

### DESCRIPTION OF EMBODIMENTS

The following describes the technical solutions in the embodiments of this application with reference to the accompanying drawings in the embodiments of this application. It is clearly that the described embodiments are merely a part rather than all of the embodiments of this application. All other embodiments obtained by a person of ordinary skill in the art based on the embodiments of this application without creative efforts shall fall within the protection scope of this application.

A semiconductor device is an electronic device whose conductivity is between conductivity of a good conductor and that of an insulator, and completes a specific function by using a special electrical feature of a semiconductor material, and may be used to generate, control, receive, transform, and amplify a signal, and perform energy conversion. A commonly used metal-oxide semiconductor field-effect transistor (Metal-Oxide-Semiconductor Field-Effect Transistor, MOSFET) is used as an example. The MOSFET may also be referred to as a MOS transistor. The MOS transistor is widely used in a high-voltage and large-current scenario, such as an inverter, a switch power supply, or a motor drive. For example, because of advantages such as a fast thermally conductive rate of a substrate and fast reverse recovery, a silicon carbide MOS has a better development prospect in a power device direction.

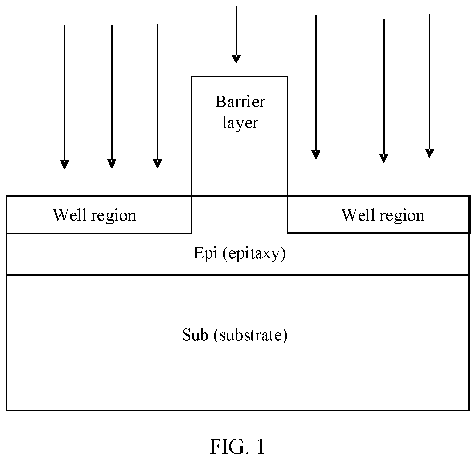

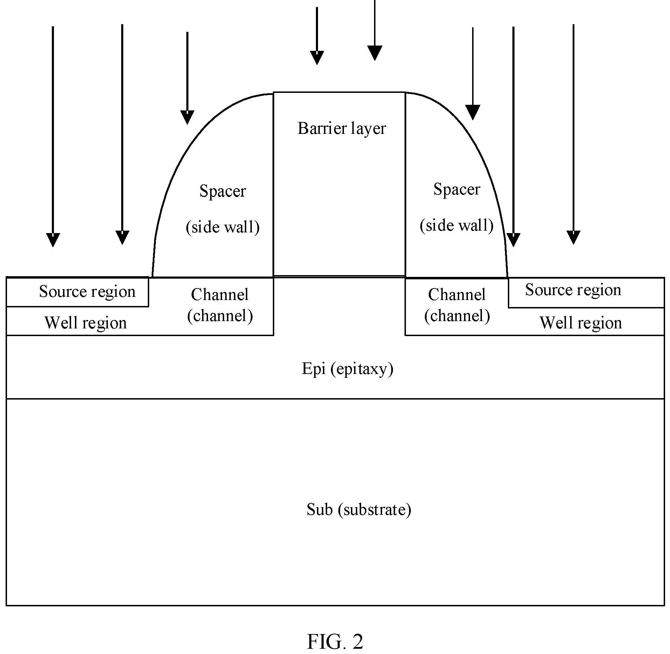

Generally, to improve power conversion efficiency, a semiconductor device with lower conduction resistance needs to be manufactured. Silicon carbide, a semiconductor device, is used as an example. In a process of manufacturing a silicon carbide chip, a hard mask serving as a dielectric component usually needs to be used to block implantation of a high-energy ion, to form semiconductor impurities with different properties. In a process of manufacturing a self-aligned channel, a side wall is formed beside the hard mask and then an ion is implanted, to naturally form a self-aligned channel. A conventional processing of manufacturing a self-aligned channel is described below by using FIG. 1 and FIG. 2.

As shown in FIG. 1, a substrate and an epitaxy (or referred to as an epitaxial layer) are used as a semiconductor base, and an arrow direction indicates an implantation direction of an ion (used to form a well region). In a process of forming a well region on the epitaxial layer, a barrier layer (or referred to as a hard mask) is first used to block implantation of some ions, and the well region is formed below a surface of the semiconductor base other than the barrier layer.

As shown in FIG. 2, after the well region is formed as shown in FIG. 1, a dielectric layer continues to be deposited on the hard mask, and then a side wall (Spacer) is formed through dry etching. An arrow direction indicates an implantation direction of an ion (used to form a source region and a channel). The ion is implanted into the source region to naturally form a self-aligned channel (Channel).

Specifically, in a process of forming a well region in a semiconductor device shown in FIG. 1, the hard mask needs to be deposited on a semiconductor surface to prevent implantation of a high-energy ion, and an ion is implanted on the semiconductor surface to form the well region. Further, in a process of forming a source region and a channel in a semiconductor device shown in FIG. 2, the dielectric layer needs to be deposited on a semiconductor surface beside the hard mask to form the side wall (spacer), to block implantation of a high-energy ion. Then, an ion is implanted on the semiconductor surface, so that the channel is formed below a semiconductor surface covered by the side wall, and the source region is formed below each of a semiconductor surface not covered by the barrier layer and a semiconductor surface not covered by the side wall.

A thickness of the hard mask depends on implanted ion energy, and larger energy requires a thicker hard mask. It can be learned from the foregoing process that in the process of forming a well region and the process of forming a source region, thicknesses of the barrier layer (that is, the hard mask) are equal to each other. However, depth requirement of the source region is lower than a depth requirement of the well region. It is clearly that a height of the barrier layer used in the process of forming a source region is redundant. In addition, because the height of the barrier layer is large, that is, a step used to form the side wall is large, it is prone to cause poor uniformity of a deposited side wall dielectric. Consequently, the formed side wall is prone to break and collapse. As a result, in the process of forming a channel in the semiconductor device, a width of the formed channel is large, and conduction resistance of the semiconductor device also increases accordingly.

Conduction resistance of the semiconductor device is an important parameter for measuring quality of the semiconductor device. The conduction resistance is directly associated with an area of the semiconductor device, and the conduction resistance is positively correlated with the area of the semiconductor device. An increase in the area of the semiconductor device directly causes an increase in manufacturing costs of the semiconductor device.

Based on the implementation processes shown in FIG. 1 and FIG. 2, in one aspect, how to reduce the conduction resistance of the semiconductor device to improve a yield rate of the semiconductor device and reduce manufacturing costs of the semiconductor device is an unresolved technical problem in a current solution. In another aspect, the thickness of the hard mask that blocks ion implantation is relatively large, a process of depositing and etching the side wall is difficult, and the formed side wall is large in size and is not uniform, which results in poor device uniformity, and further increases manufacturing costs. Therefore, how to manufacture a more uniform side wall with a smaller size to form a channel with a smaller width, to reduce the conduction resistance of the semiconductor device and increase a yield rate of the semiconductor device is a technical problem that needs to be urgently resolved currently.

To resolve the problem, embodiments of this application provide a semiconductor device manufacturing method and a semiconductor device, to form a self-aligned channel with a smaller size and better uniformity to reduce conduction resistance of the semiconductor device, thereby improving a yield rate of the semiconductor device and reducing manufacturing costs of the semiconductor device.

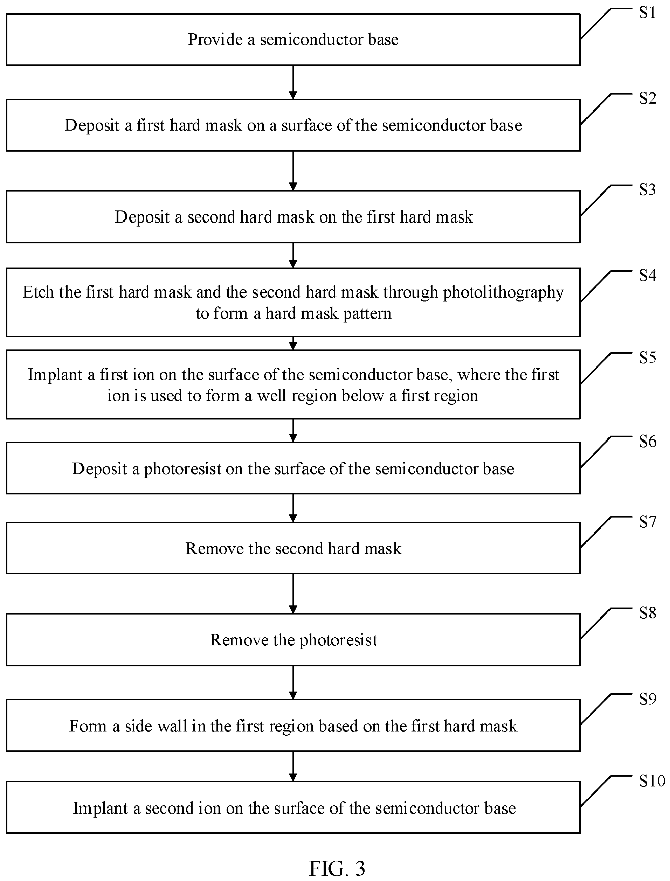

FIG. 3 is a semiconductor device manufacturing method according to an embodiment of this application. The method includes the following steps.

S1. Provide a semiconductor base.

In this embodiment, the method shown in FIG. 3 may be applied to a process of manufacturing a semiconductor device, and may be specifically applied to a process of manufacturing a semiconductor device. In step S1, the semiconductor base is provided.

Specifically, in the semiconductor base provided in step S1, the semiconductor base may include an etching stop layer and a substrate located on one side of the etching stop layer, and the other side of the etching stop layer forms a surface of the semiconductor base. An ion needs to be implanted in a process of forming a well region, a source region, and a channel in the semiconductor device, and an ion implantation concentration presents a distribution curve in terms of depth of the semiconductor device, so that a surface of the semiconductor device is from small to large, subsequently becomes flat, and then descends. Therefore, in the semiconductor base provided in step S1, the etching stop layer is disposed in the semiconductor base, and the other side of the etching stop layer forms the surface of the semiconductor base, so that in an implantation process after the ion (including a first ion used to form a well region or a second ion used to form a source region) passes through the etching stop layer, damage to the substrate can be reduced by disposing the etching stop layer, and a depth of the implanted ion can be implemented by controlling a thickness of the etching stop layer, thereby further improving a yield rate of the semiconductor device.

The substrate (Substrate, Sub) may indicate a substrate of a semiconductor wafer, which is made of materials such as silicon, silicon carbide, and sapphire.

In addition, a component of the etching stop layer is a silicon compound. The silicon compound may include polycrystalline silicon, silicon nitride, silicon oxide, silicon carbide, and the like. The composition component of the etching stop layer may be one silicon compound or a mixture of a plurality of silicon compounds. In other words, the etching stop layer may be implemented in a plurality of manners. In addition, a thickness of the etching stop layer may range from 10 nanometers to 500 nanometers. Specifically, a thickness value of the etching stop layer is limited to 10 nanometers to 500 nanometers, so that on the premise that the etching stop layer has a specific thickness to fulfill the foregoing function, it can be avoided that the etching stop layer is difficult to be removed subsequently due to an excessively large thickness value.

Optionally, in this embodiment, the etching stop layer is not mandatory. The etching stop layer is disposed to ensure that a semiconductor layer is not etched when a hard mask is etched. However, considering that slight etching of a surface of the semiconductor layer does not affect normal operation of the semiconductor device, whether the etching stop layer is disposed is not limited herein.

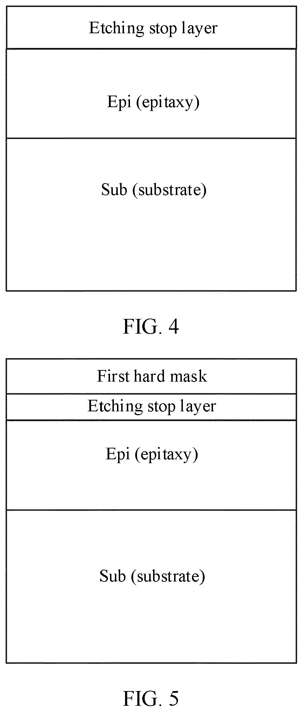

Further, in the semiconductor base provided in step S1, the semiconductor base further includes an epitaxial layer (or referred to as an epitaxy). As shown in FIG. 4, the epitaxial layer is located between the etching stop layer and the substrate. Specifically, the semiconductor base may further include the epitaxial layer located between the etching stop layer and the substrate. Implantation of an ion (including a first ion used to form a well region or a second ion used to form a source region) may form a well region, a source region, and a channel on the epitaxial layer, so that the present invention is applicable to a semiconductor structure including a substrate and an epitaxial layer. Optionally, the epitaxial layer has high resistivity relative to the substrate, and the substrate has low resistivity relative to the epitaxial layer. In this case, the epitaxial layer with high resistivity ensures that the semiconductor device has relatively high breakdown voltage, and the substrate with low resistivity can reduce resistance of the semiconductor device, thereby reducing a saturation voltage drop. The epitaxial layer (epitaxial, Epi) may specifically indicate a technology used in a process of manufacturing a semiconductor device to grow a new crystal on an original chip to manufacture a new semiconductor layer.

Optionally, the etching stop layer may be deposited on the epitaxial layer in a plurality of manners, for example, based on low-pressure chemical vapor deposition (low-pressure chemical vapor deposition, LPCVD), plasma-enhanced chemical vapor deposition (plasma-enhanced chemical vapor deposition, PECVD), or in another manner. This is not limited herein.

It should be noted that in this embodiment and a subsequent embodiment, only an example in which the semiconductor base includes a combination of the etching stop layer, the epitaxy, and the substrate shown in FIG. 4 is used for description. It is clearly that the semiconductor base provided in step S1 may be implemented in another manner other than FIG. 4. For example, the semiconductor base may include only the substrate; or the semiconductor base may include only the substrate and the etching stop layer; or the semiconductor base may include only the substrate and the epitaxial layer; or the semiconductor base is implemented in another manner. This is not limited herein.

S2. Deposit a first hard mask on the surface of the semiconductor base.

In this embodiment, as shown in FIG. 5, based on the semiconductor base provided in step S1, the first hard mask is deposited on the surface of the semiconductor base.

Optionally, the first hard mask may be deposited on the surface of the semiconductor base in a plurality of manners, for example, based on low-pressure chemical vapor deposition (low-pressure chemical vapor deposition, LPCVD), plasma-enhanced chemical vapor deposition (plasma-enhanced chemical vapor deposition, PECVD), or in another manner. This is not limited herein.

S3. Deposit a second hard mask on the first hard mask.

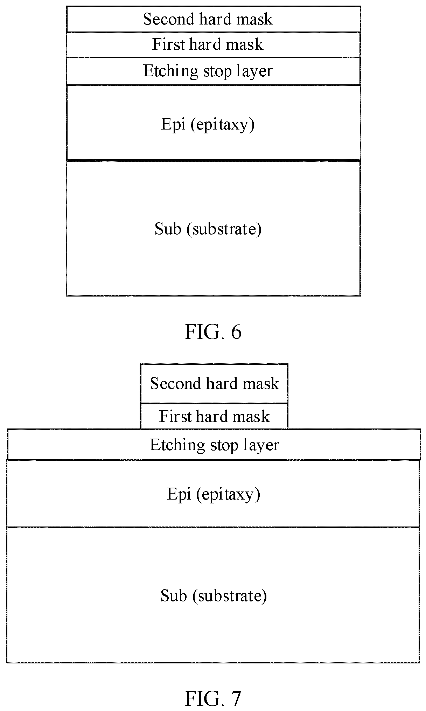

In this embodiment, as shown in FIG. 6, based on the semiconductor base in step S2 on which the first hard mask is deposited, the second hard mask is deposited on the first hard mask.

Optionally, the second hard mask may be deposited on the first hard mask in a plurality of manners, for example, based on low-pressure chemical vapor deposition (low-pressure chemical vapor deposition, LPCVD), plasma-enhanced chemical vapor deposition (plasma-enhanced chemical vapor deposition, PECVD), or in another manner. This is not limited herein.

It should be noted that in step S2, the first hard mask may include one layer of hard mask, or may include a plurality of layers of hard masks. In addition, when the first hard mask includes a plurality of layers of hard masks, composition components of different layers of hard masks may be the same or different. In this case, in a process of removing the first hard mask, etching (dry etching or wet etching) may be performed one or more times. This is not limited herein. Similarly, in step S3, the second hard mask may also include one layer of hard mask, or may include a plurality of layers of hard masks. In addition, when the second hard mask includes a plurality of layers of hard masks, composition components of different layers of hard masks may be the same or different. In this case, in a process of removing the second hard mask, etching (dry etching or wet etching) may be performed one or more times. This is not limited herein.

Specifically, a component of the second hard mask is different from a component of the first hard mask. The first hard mask and the second hard mask that have different components are disposed, so that in the subsequent process of removing the second hard mask, an etching condition that an etching rate at which the component of the second hard mask is etched is relatively large and an etching rate at which the component of the first hard mask is etched is relatively small may be set to reduce damage to the first hard mask in the process of removing the second hard mask.

Further, an etching selectivity ratio of the second hard mask to the first hard mask is greater than 10 to 1. The etching selectivity ratio may indicate a fast/low etching rate of one material relative to another material in a same etching condition. Specifically, in the subsequent process of removing the second hard mask, damage to the first hard mask can be reduced in the process of removing the second hard mask, because the etching selectivity ratio of the second hard mask to the first hard mask is greater than 10 to 1, that is, in a specific etching condition, an etching rate of the second hard mask is far greater than an etching rate of the first hard mask.

Optionally, the etching selectivity ratio of the second hard mask to the first hard mask is greater than 1 to 1.

Optionally, the component of the second hard mask is the same as the component of the first hard mask. In the subsequent process of removing the second hard mask, an etching condition (for example, an etching liquid concentration or an etching temperature) may be controlled to reduce damage to the first hard mask in the process of removing the second hard mask.

In addition, the component of the second hard mask and the component of the first hard mask both are silicon compounds. The silicon compound may include polycrystalline silicon, silicon nitride, silicon oxide, silicon carbide, and the like. The composition component of the first hard mask may be one silicon compound or a mixture of a plurality of silicon compounds. Similarly, the composition component of the second hard mask may also be one silicon compound or a mixture of a plurality of silicon compounds. In other words, the first hard mask and the second hard mask may be implemented in a plurality of manners.

In addition, to avoid corrosion of the etching stop layer in the subsequent process of etching the first hard mask or the subsequent process of etching the second hard mask, the component of the etching stop layer may be different from that of the first hard mask, or the component of the etching stop layer may be different from that of the second hard mask. Subsequently, an etching condition may be controlled to avoid corrosion of the etching stop layer when the first hard mask (or the second hard mask) is etched.

Optionally, an etching selectivity ratio of the first hard mask to the etching stop layer may be greater than 10 to 1.

In a possible implementation, a thickness of the first hard mask ranges from 0.1 microns to 3 microns.

In a possible implementation, a thickness of the second hard mask ranges from 0.1 microns to 3 microns.

S4. Etch the first hard mask and the second hard mask through photolithography to form a hard mask pattern.

In this embodiment, as shown in FIG. 7, based on the obtained first hard mask and second hard mask in step S3 that are successively stacked, the first hard mask and the second hard mask are etched through photolithography to form the hard mask pattern.

Specifically, based on FIG. 6, in step S4, a photoresist (or referred to as a photoresist, or referred to as a photoresist, or referred to as a photoresist, and so on) may be coated outside the second hard mask through glue spreading to obtain the hard mask pattern. Then, after the first hard mask and the second hard mask other than the hard mask pattern are etched through dry etching, wet etching, or in another etching manner, the photoresist is removed to obtain the hard mask pattern shown in FIG. 7.

In addition, it can be learned from FIG. 7 that in step S4, the etching stop layer can protect the epitaxial layer. To be specific, in a process of forming the hard mask pattern, the etching stop layer avoids corrosion of the epitaxial layer in the semiconductor device in the process of etching the first hard mask and the second hard mask, and avoids damage to a semiconductor surface in a subsequent ion implantation process.

S5. Implant a first ion on the surface of the semiconductor base, where the first ion is used to form a well region below a first region.

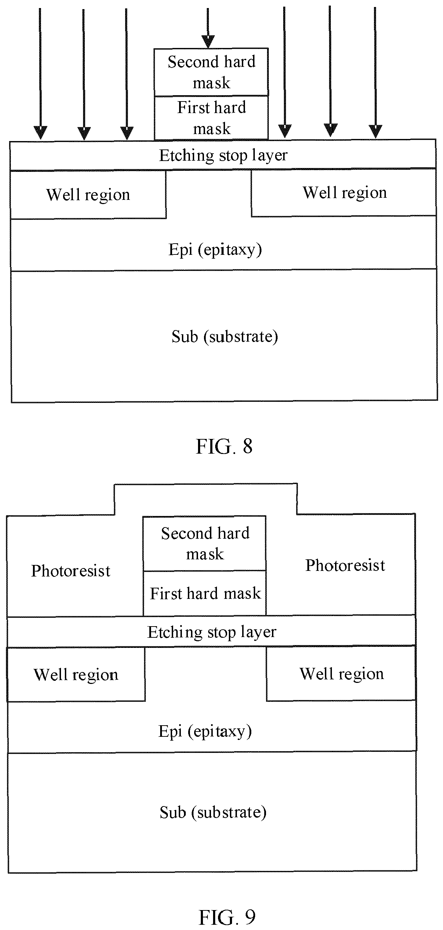

In this embodiment, as shown in FIG. 8, an arrow direction indicates an implantation direction of the first ion. Based on the hard mask pattern obtained in step S4, the first ion that is used to form the well region below the first region is implanted on the surface of the semiconductor base. The first region is a region other than the hard mask pattern on the surface of the semiconductor base.

Optionally, after step S5, step S6 to step S10 may be performed in sequence based on an arrow direction shown in FIG. 3. Alternatively, after step S5, step S7, step S9, and step S10 may be directly separately performed based on the arrow direction shown in FIG. 3 by skipping (or not performing) step S6 and step S8. This is not limited herein.

S6. Deposit a photoresist on the surface of the semiconductor base.

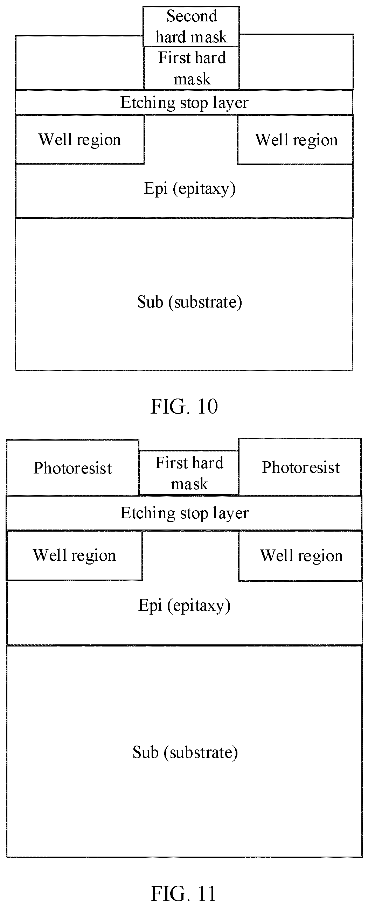

In this embodiment, as shown in FIG. 10, based on the semiconductor device that is obtained in step S5 and in which the well region is formed, the photoresist is deposited on the surface of the semiconductor base. The photoresist covers a surface of the first region.

Step S6 is an optional execution step.

Optionally, as shown in FIG. 9, the photoresist may further cover an outer surface of the second hard mask.

Optionally, a thickness of the photoresist ranges from 0.3 microns to 3 microns.

S7. Remove the second hard mask.

In this embodiment, as shown in FIG. 11, the second hard mask is etched through dry etching or wet etching, so that the first hard mask is exposed. The photoresist coated in step S6 may protect the first region, so as to avoid corrosion of the semiconductor base in the process of removing the second hard mask in step S7.

In Step S7, the second hard mask may be removed based on execution of step S5 (that is, step S6 is not performed); or the second hard mask may be removed based on execution of step S6. This is not limited herein.

In a possible implementation, as shown in step S6, the photoresist may further cover the second hard mask in an implementation process shown in FIG. 9. In this case, in step S7, the process of removing the second hard mask specifically includes: removing the second hard mask after the photoresist covering the second hard mask is removed. Specifically, the photoresist deposited on the surface of the semiconductor base not only covers the surface of the first region but also covers the surface of the second hard mask. In the subsequent process of removing the second hard mask, the photoresist covering the second hard mask is removed before the second hard mask is removed. The photoresist may be indiscriminately deposited in all regions on the surface of the semiconductor base, so that the photoresist covers the surface of the second hard mask and the surface of the first region, and the photoresist unnecessarily needs to be deposited in a specific region, thereby reducing complexity of depositing the photoresist on the surface of the semiconductor base.

In addition, in an execution process of step S7, the second hard mask is removed through wet etching or dry etching, and an etching condition may be restricted, so that medicinal liquid in wet etching or dry etching causes no damage or relatively slight damage to the first hard mask.

S8. Remove the photoresist.

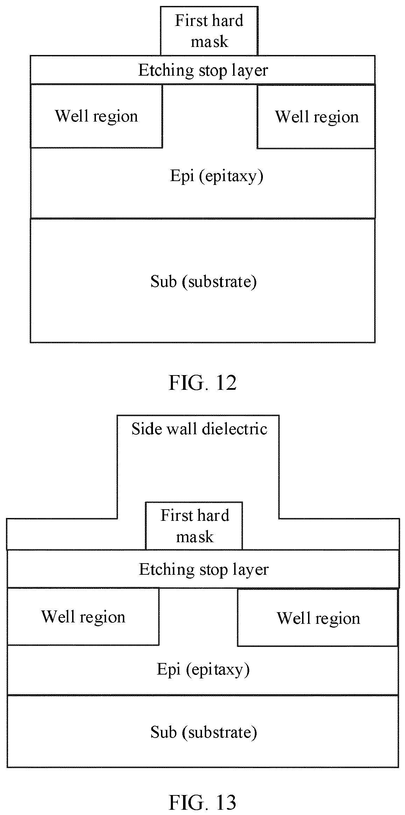

In this embodiment, as shown in FIG. 12, the photoresist is etched through dry etching or wet etching, so that the first region on the surface of the semiconductor base is exposed, that is, a region that is on a surface of the etching stop layer and that is not covered by the first hard mask is exposed.

If step S6 is performed, step S8 is performed; or if step S6 is not performed, step S8 does not need to be performed herein.

S9. Form a side wall in the first region based on the first hard mask.

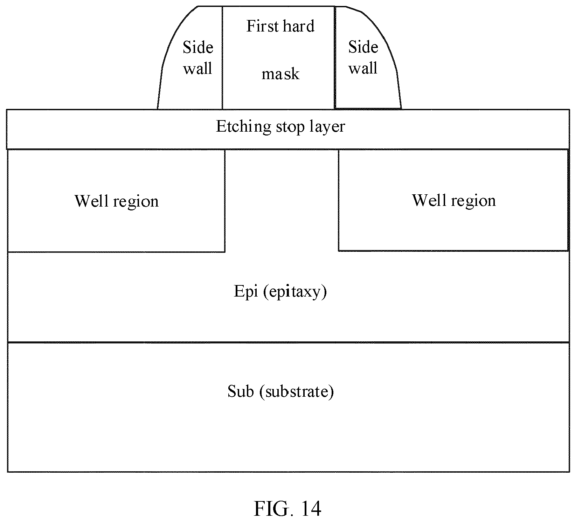

In this embodiment, as shown in FIG. 13, based on the exposed first hard mask and first region that are obtained in step S8 (or step S7), a layer of side wall dielectric may be deposited on the surface of the semiconductor base. Then, the side wall dielectric is etched through dry etching or wet etching to obtain a side wall structure shown in FIG. 14.

Optionally, in FIG. 13, the side wall dielectric may be deposited on the surface of the semiconductor base in a plurality of manners, for example, based on low-pressure chemical vapor deposition (low-pressure chemical vapor deposition, LPCVD), plasma-enhanced chemical vapor deposition (plasma-enhanced chemical vapor deposition, PECVD), or in another manner. This is not limited herein.

In addition, a component of the side wall dielectric may be different from the component of the first hard mask.

S10. Implant a second ion on the surface of the semiconductor base.

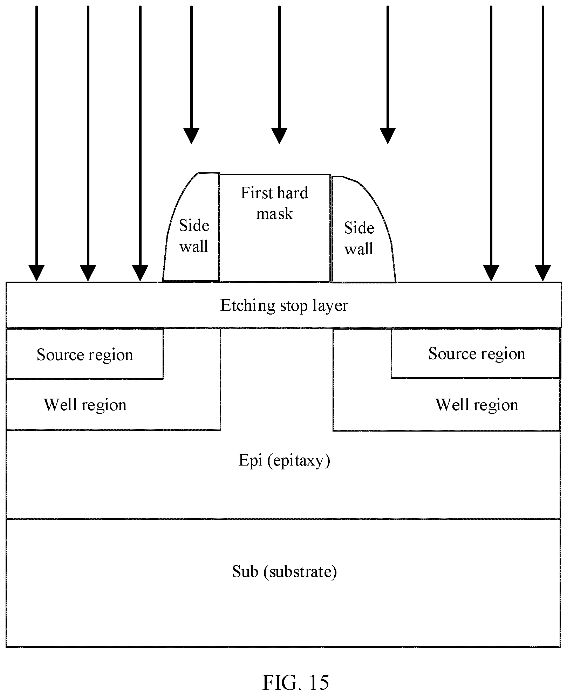

In this embodiment, as shown in FIG. 15, based on the side wall structure obtained in step S9, the second ion is implanted on the surface of the semiconductor base.

Specifically, the second ion is used to form a source region below a second region and form a channel (not shown in FIG. 15) below a third region. The second region is a region that is in the first region and that is not covered by the side wall, and the third region is a region that is in the first region and that is covered by the side wall.

In addition, ion energy of the first ion is greater than ion energy of the second ion. Ion energy of the first ion that is implanted on the surface of the semiconductor base and that is used to form the well region is greater than ion energy of the second ion that is implanted on the surface of the semiconductor base and that is used to form the source region and the channel. Because ion energy is positively correlated with an implantation depth, a depth of the well region formed below the surface of the semiconductor base is greater than a depth of the source region formed below the surface of the semiconductor base, thereby meeting depth requirements in different regions in the semiconductor device.

In a possible implementation solution, after step S10, the method may further include: removing the first hard mask and the side wall. After the source region and the channel are formed below the surface of the semiconductor base, the first hard mask and the side wall that cover the surface of the semiconductor base may be further removed to expose the surface of the semiconductor base.

Specifically, when the channel formed for the semiconductor base in step S10 does not need to be further processed, for example, when the substrate (or the epitaxial layer that may exist) of the semiconductor base is silicon carbide, after the first hard mask and the side wall are removed, gate oxide and a gate dielectric may be further formed on the exposed surface of the semiconductor base, and a gate structure is formed through etching to meet a power-on requirement of the semiconductor device in a specific scenario.

In addition, when the channel formed for the semiconductor base in step S10 does not need to be further processed, for example, when the substrate (or the epitaxial layer that may exist) of the semiconductor base is a silicon crystal, the first hard mask and the side wall may not need to be removed, and the channel is transferred, through thermal diffusion, to be below the first hard mask or the side wall whose material is polysilicon (polysilicon, poly). In other words, the first hard mask and the side wall may be directly used as a gate structure of the semiconductor device, so as to meet a pass-through requirement of the semiconductor device in a specific scenario.

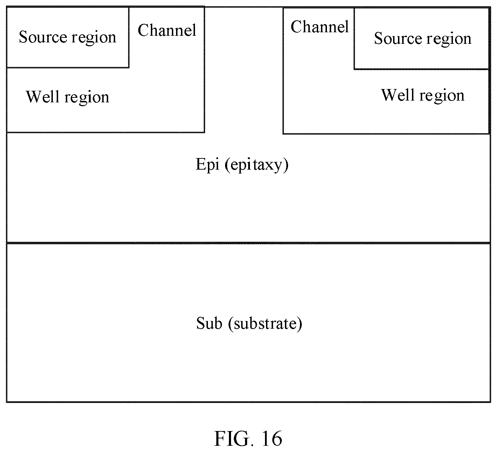

In this embodiment, if the first hard mask and the side wall need to be removed, as shown in FIG. 16, based on the well region, the source region, and the channel that are obtained after processing in step S10, the first hard mask and the side wall located on the surface of the semiconductor base are removed through dry etching or wet etching, so that the surface of the semiconductor base is exposed to obtain the semiconductor device.

In addition, it can be learned from step S1 that when the surface of the semiconductor base further includes the etching stop layer, after the first hard mask and the side wall are removed in step S11, the method may further include: removing the etching stop layer. To be specific, the etching stop layer is removed through dry etching or wet etching.

In this embodiment, a barrier layer used to form the well region includes the first hard mask and the second hard mask, and a barrier layer used to form the source region includes only the first hard mask. It is clearly that a thickness of the barrier layer used to form the source region is less than a thickness of the barrier layer used to form the well region. In other words, the thickness of the barrier layer used to form the source region is reduced, so that a side wall with a smaller size can be obtained, so as to form a self-aligned channel with a smaller size and better uniformity to reduce conduction resistance of the semiconductor device, thereby improving a yield rate of the semiconductor device and reducing manufacturing costs of the semiconductor device.

An embodiment of this application further provides a semiconductor device. The semiconductor device may be a semiconductor device manufactured from the semiconductor base shown in FIG. 4 to FIG. 16, and the semiconductor device may be manufactured by using the method shown in FIG. 3. The semiconductor device includes a channel.

An embodiment of this application further provides a chip. The chip may include a semiconductor device manufactured from the semiconductor base shown in FIG. 4 to FIG. 16, and the semiconductor device may be manufactured by using the method shown in FIG. 3.

## Claims

1. A semiconductor device manufacturing method, comprising:
providing a semiconductor base;
depositing a first hard mask on a surface of the semiconductor base;
depositing a second hard mask on the first hard mask;
etching the first hard mask and the second hard mask through photolithography to form a hard mask pattern;
implanting a first ion on the surface of the semiconductor base, wherein the first ion is used to form a well region below a first region, and the first region is a region other than the hard mask pattern on the surface of the semiconductor base;
removing the second hard mask;
forming a side wall in the first region based on the first hard mask; and
implanting a second ion on the surface of the semiconductor base, wherein the second ion is used to form a source region below a second region and form a channel below a third region, the second region is a region that is in the first region and that is not covered by the side wall, and the third region is a region that is in the first region and that is covered by the side wall.

2. The method according to claim 1, wherein
after the implanting a first ion on the surface of the semiconductor base and before the removing the second hard mask, the method further comprises:
depositing a photoresist on the surface of the semiconductor base, wherein the photoresist covers a surface of the first region; and
after the removing the second hard mask and before the forming a side wall in the first region based on the first hard mask, the method further comprises:
removing the photoresist.

3. The method according to claim 2, wherein the photoresist further covers the second hard mask; and
the removing the second hard mask comprises:
removing the second hard mask after the photoresist covering the second hard mask is removed.

4. The method according to claim 2 or 3, wherein
a thickness of the photoresist ranges from 0.3 microns to 3 microns.

5. The method according to any one of claims 1 to 4, wherein after the implanting a second ion on the surface of the semiconductor base, the method further comprises:
removing the first hard mask and the side wall.

6. The method according to claim 5, wherein the semiconductor base comprises an epitaxy, a substrate located on one side of the epitaxy, and an etching stop layer located on the other side of the epitaxy; and the etching stop layer forms the surface of the semiconductor base; and
after the removing the first hard mask and the side wall, the method further comprises:
removing the etching stop layer.

7. The method according to any one of claims 1 to 6, wherein
a component of the second hard mask is different from a component of the first hard mask.

8. The method according to any one of claims 1 to 7, wherein
the component of the second hard mask and the component of the first hard mask both are silicon compounds.

9. The method according to any one of claims 1 to 8, wherein
an etching selectivity ratio of the second hard mask to the first hard mask is greater than 10 to 1.

10. The method according to any one of claims 1 to 9, wherein
a thickness of the first hard mask ranges from 0.1 microns to 3 microns.

11. The method according to any one of claims 1 to 10, wherein
a thickness of the second hard mask ranges from 0.1 microns to 3 microns.

12. The method according to any one of claims 6 to 11, wherein
a component of the etching stop layer is a silicon compound.

13. The method according to any one of claims 6 to 12, wherein a thickness of the etching stop layer ranges from 10 nanometers to 500 nanometers.

14. The method according to any one of claims 6 to 13, wherein the component of the etching stop layer is different from the component of the first hard mask.

15. A semiconductor device, wherein the semiconductor device is manufactured by using the method according to any one of claims 1 to 14.
